# EUROPÄISCHE PATENTSCHRIFT

(11) **EP 1 608 057 B1**
(45) Veröffentlichungstag und Bekanntmachung des Hinweises auf die Patenterteilung: **05.11.2008**
(21) Anmeldenummer: 05010703.6
(22) Anmeldetag: 18.05.2005
(51) Int. Cl.: H02P 7/18, H02P 6/12, H02P 7/28, H02H 7/08, H03K 17/16

(54) **Elektronisch kommutierter Gleichstrommotor mit einer in seiner Zuleitung angeordneten Schutzschaltung**
Electronically commutated DC motor with protection circuit arranged in the supply wires
Moteur à courant continu commuté électroniquement avec un circuit de protection connecté dans les câbles d'alimentation

(30) Priorität: 14.06.2004 DE 102004029049
(43) Veröffentlichungstag der Anmeldung: 21.12.2005
(73) Patentinhaber: ebm-papst St. Georgen GmbH & Co. KG, 78112 St. Georgen (DE)
(72) Erfinder: Dornhof, Konstantin, 78194 Immendingen (DE)
(74) Vertreter: Raible, Hans

(56) Entgegenhaltungen:
- DE-A1- 10 232 716
- DE-C1- 19 502 016
- PATENT ABSTRACTS OF JAPAN Bd. 2003, Nr. 09, 3. September 2003 (2003-09-03) -& JP 2003 133928 A (DENSO CORP), 9. Mai 2003 (2003-05-09)
- PATENT ABSTRACTS OF JAPAN Bd. 006, Nr. 175 (P-141), 9. September 1982 (1982-09-09) -& JP 57 091481 A (RICOH ELEMEX CORP), 7. Juni 1982 (1982-06-07)

## Beschreibung

Die Erfindung betrifft einen elektrisch kommutierten Gleichstrommotor mit einer in seiner Zuleitung angeordneten Schutzschaltung zur Reduzierung elektrischer Störungen.

Beim Betrieb von Gleichstrommotoren ist das Auftreten von elektrischen Störungen problematisch. Insbesondere kann das Auftreten von elektrischen Störungen an Steuerschaltungen, die zur elektronischen Kommutierung der Ströme in einem Gleichstrommotor dienen, eine Steuerung des Gleichstrommotors beeinträchtigen. Derartige elektrische Störungen umfassen sowohl energiereiche Transientenimpulse, als auch Niederspannungsstörungen im Bereich von 50 Hz bis 20 kHz mit Amplituden von 6 V Spitze-Spitze.

Aus dem Stand der Technik bekannte Schutzschaltungen verwenden Varistoren und LC-Filter oder Siebkondensatoren, um Gleichstrommotoren vor elektrischen Störungen zu schützen. Die Varistoren dienen zur Absorption der energiereichen Transientenimpulse, und die LC-Filter oder Siebkondensatoren dienen zum Ausfiltern der Niederspannungsstörungen. Aufgrund der erforderlichen Größe, der beschränkten Arbeitstemperatur, und der beschränkten Lebensdauer von LC-Filtern oder Siebkondensatoren ist deren Verwendung jedoch kompliziert und nur eingeschränkt möglich. Die Verwendung von Varistoren ist aufgrund der erforderlichen Dimensionierung der Varistoren aufwendig und kostenintensiv.

Die DE-C1-195 02 016 betrifft eine Überstromsicherung für einen Lüftermotor in einem Kraftfahrzeug. Der Strom zu diesem Motor wird von einem Leistungs-MOSFET gesteuert, welcher auch als Widerstand zur Strommessung dient. Dieser Widerstand hat einen Wert von etwa 0,04 Ohm, und bei einem Strom von 20 A entsteht deshalb am MOSFET ein Spannungsabfall von 20 * 0,04 = 0,8 V. Diese Spannung wird dazu verwendet, einen Thyristor einzuschalten, der so lange leitend bleibt, bis der Lüftermotor abgeschaltet wird. So soll erreicht werden, dass eine einmal ausgelöste Überstrom-Abschaltung so lange wirksam bleibt, bis der Lüfter wieder aus- und eingeschaltet wird.

Die japanische Patent-Offenlegungsschrift JP 2003/133928 A betrifft ebenfalls einen Motor, dessen Strom von einem Leistungs-MOSFET gesteuert wird. Zu diesem Motor ist eine Freilaufdiode antiparallel geschaltet. Der MOSFET hat eine Gate-Kapazität, die bei einem Einschaltbefehl zuerst von einem niedrigen Strom geladen wird, und dann von einem höheren Strom, wenn sich die Spannung an der Freilaufdiode ändert. Wird der MOSFET ausgeschaltet, so wird diese Kapazität zuerst durch einen großen Strom entladen, und dann durch einen kleinen Strom, wenn sich die Spannung an der Freilaufdiode ändert. Hierdurch sollen hochfrequente Störungen bei den Schaltvorgängen des MOSFET vermieden werden, ohne dass die Schaltverluste in diesem MOSFET ansteigen.

Es ist eine Aufgabe der vorliegenden Erfindung, einen verbesserten elektronisch kommutierten Gleichstrommotor bereit zu stellen. Diese Aufgabe wird durch einen Gleichstrommotor nach Anspruch 1 gelöst.

Der Erfindung liegt die Erkenntnis zugrunde, dass eine Reduzierung von elektrischen Störungen beim Betrieb von Gleichstrommotoren durch eine aktive Schutzschaltung erreicht werden kann. Eine aktive Schutzschaltung wird vorzugsweise durch eine Analysatorschaltung, einen Leistungsregler und eine Ansteuerung für den Leistungsregler realisiert. Ein Grundgedanke der Erfindung besteht nun darin, dass die Ansteuerung den Leistungsregler derart ansteuert, dass der Leistungsregler eine mit elektrischen Störungen behaftete Eingangsspannung der Schutzschaltung beeinflusst, um einem zugeordneten Gleichstrommotor eine im Wesentlichen von elektrischen Störungen freie Versorgungsspannung zuzuführen. Hierfür ist die Analysatorschaltung vorgesehen, die die Eingangsspannung analysiert und die elektrischen Störungen in dieser Eingangsspannung detektiert.

Gemäß einer bevorzugten Ausführungsform der Erfindung wird der Leistungsregler als Längstransistor ausgebildet. Hierbei bewirkt die Ansteuerung, dass der Längstransistor voll leitend ist, wenn die Eingangsspannung im Wesentlichen frei von elektrischen Störungen ist. Hierdurch wird die Eingangsspannung dem Gleichstrommotor im Wesentlichen ohne Verluste als Versorgungsspannung zugeführt. Beim Auftreten von elektrischen Störungen in Form von Transientimpulsen bewirkt die Ansteuerung, dass der Längstransistor die Amplitude der von der Schutzschaltung erzeugten Versorgungsspannung auf einen vorgegebenen Wert begrenzt.

Gemäß einer weiteren bevorzugten Ausführungsform umfasst die Analysatorschaltung ein RC-Glied. Durch das RC-Glied werden bei elektrischen Störungen in Form von Niederspannungen mit Frequenzen von 50 Hz bis 20 kHz in der Eingangsspannung die Frequenzkomponenten ausgefiltert.

Es wird eine Reduzierung von elektrischen Störungen beim Betrieb von Gleichstrommotoren erfindungsgemäß unter Verwendung einer vergleichsweise einfachen und kostengünstigen Schutzschaltung ermöglicht. Die Erfindung ist dabei nicht auf einen bestimmten Motorentyp beschränkt.

Weitere Einzelheiten und vorteilhafte Weiterbildungen der Erfindung ergeben sich aus den im Folgenden beschriebenen und in den Zeichnungen dargestellten Ausführungsbeispielen. Es zeigt:
- Fig. 1: ein Blockdiagramm einer Schutzschaltung zur Reduzierung von elektrischen Störungen gemäß der Erfindung,
- Fig. 2: ein stark vereinfachtes Schaltbild einer Schutzschaltung zur Reduzierung von elektrischen Störungen gemäß einer ersten Ausführungsform der Erfindung,
- Fig. 3: eine schematische Darstellung einer Eingangs- und Ausgangsspannung der Schutzschaltung von Fig. 2 gemäß einer Ausführungsform der Erfindung,
- Fig. 4: ein vereinfachtes Schaltbild einer Schutzschaltung zur Reduzierung von elektrischen Störungen gemäß einer zweiten Ausführungsform der Erfindung,
- Fig. 5: ein vereinfachtes Schaltbild eines Gleichstrommotors mit der Schutzschaltung von Fig. 4,
- Fig. 6: eine schematische Darstellung einer an den Wicklungssträngen des Gleichstrommotors von Fig. 5 induzierten Spannung, und
- Fig. 7: eine schematische Darstellung einer an einer Diodenschaltung von Fig. 5 erzeugten Hilfsspannung gemäß einer Ausführungsform der Erfindung.

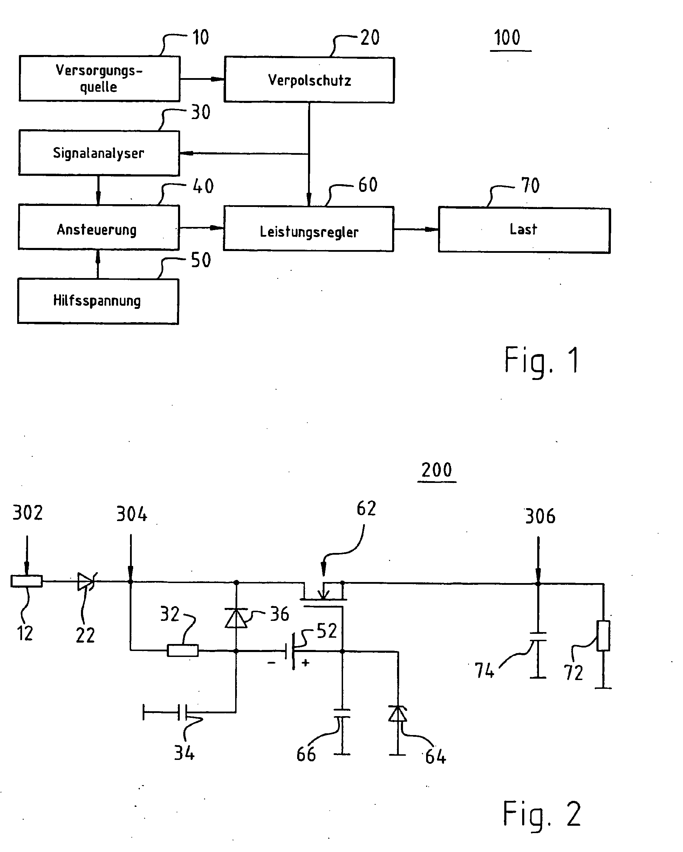

**Fig. 1** zeigt ein Blockdiagramm, welches die prinzipielle Funktionsweise einer erfindungsgemäßen Schutzschaltung 100 illustriert. Die erfindungsgemäße Schutzschaltung 100 ist dazu ausgebildet, elektrische Störungen in einem Ausgangssignal einer Versorgungsquelle 10 beim Betrieb einer Last 70 zu reduzieren. Hierzu führt die Schutzschaltung 100 das Ausgangssignal der Versorgungsquelle 10 über einen Verpolschutz 20 einer Analysatorschaltung 30 und einem Leistungsregler 60 zu. Eine Ansteuerung 40 empfängt das Ausgangssignal der Analysatorschaltung 30 und das Ausgangssignal einer Hilfsspannungsquelle 50. Ausgangsseitig ist die Ansteuerung 40 mit dem Leistungsregler 60 verbunden. Das Ausgangssignal des Leistungsreglers 60 wird der Last 70 zugeführt und ist im Wesentlichen frei von elektrischen Störungen.

Gemäß einer bevorzugten Ausführungsform der vorliegenden Erfindung stellt die Versorgungsquelle 10 eine zum Betrieb der Last 70 erforderlichen Versorgungsspannung bereit. Um eine inkorrekte Spannungspolarität oder negative Spannungsstörungen an der Last 70 zu vermeiden, wird die Versorgungsspannung dem Verpolschutz 20 zugeführt. Der Verpolschutz 20 löscht Signalkomponenten, die durch negative Spannungsstörungen entstehen und blockiert eine Signalweiterleitung bei einer inkorrekten Polarität der Versorgungsspannung. Somit wird nur eine Versorgungsspannung mit einer korrekten Polarität über den Verpolschutz 20 der Analysatorschaltung 30 und dem Leistungsregler 60 zugeführt, wobei negative Spannungsstörungen in der Versorgungsspannung blockiert werden.

Die Analysatorschaltung 30 analysiert die Versorgungsspannung und steuert die Ansteuerung 40. Die Ansteuerung 40 steuert den Leistungsregler 60 unter Verwendung von einer im Wesentlichen konstanten Hilfsspannung von der Hilfsspannungsquelle 50 an. Spezifischer ausgedrückt, wird die Ansteuerung 40 von der Analysatorschaltung 30 derart geregelt, dass der Leistungsregler 60 eine störungsfreie Versorgungsspannung im Wesentlichen ohne Verluste der Last 70 zuführt. Beim Auftreten von elektrischen Störungen in der Versorgungsspannung wird die Ansteuerung 40 entsprechend angepasst, um den Einfluss dieser elektrischen Störungen auf die Last 70 unter Verwendung des Leistungsreglers 60 zu reduzieren. Somit ermöglicht der Leistungsregler 60, dass der Last 70 im Wesentlichen störungsfreie Energie zugeführt wird und für die Last 70 schädliche Spannungsimpulse, wie z.B. energiereiche Transientimpulse, ausreichend gedämpft werden.

**Fig. 2** zeigt ein stark vereinfachtes Schaltbild einer beispielhaften Schutzschaltung 200 zur Reduzierung von elektrischen Störungen gemäß einer ersten Ausführungsform der vorliegenden Erfindung. Die beispielhafte Schutzschaltung 200 weist eine Versorgungsspannungsquelle 12 und eine als Widerstand dargestellte Last 72 auf. Eine Plusleitung der Versorgungsspannungsquelle 12 ist mit der Anodenseite einer Diode 22 verbunden. Das Ausgangssignal der Diode 22 wird von der Kathodenseite der Diode 22 über einen Widerstand 32 dem Minus-Pol einer Hilfsspannungsquelle 52 zugeführt. Das Ausgangssignal der Diode 22 wird des Weiteren der Kathodenseite einer Diode 36 und dem Drain-Bereich eines Längstransistors (MOSFET) 62 zugeführt. Die Anodenseite der Diode 36 und der Minus-Pol der Hilfsspannungsquelle 52 sind über einen Speicherkondensator 34 mit Masse verbunden. Der Plus-Pol der Hilfsspannungsquelle ist mit dem Gate des Längstransistors 62 verbunden. Des Weiteren ist der Plus-Pol der Hilfsspannungsquelle 52 über einen Speicherkondensator 66 und eine parallel zu dem Speicherkondensator 66 angeordnete Zenerdiode 64 mit Masse verbunden. Der Source-Bereich des Längstransistors ist einerseits über die Last 72 sowie andererseits über einen Zwischenkreiskondensator 74 mit Masse verbunden.

Gemäß einer bevorzugten Ausführungsform der vorliegenden Erfindung bildet die Diode 22 einen Verpolschutz (z. B. Verpolschutz 20 von Fig. 1), welcher die Last 72 gegen falsch gepolten Anschluss schützt. Der Längstransistor 62, der Speicherkondensator 66 und die Zenerdiode 64 bilden einen Leistungsregler (z. B. Leistungsregler 60 von Fig. 1). Der Widerstand 32, der Kondensator 34 und die Diode 36 bilden eine Analysatorschaltung (z. B. Analysatorschaltung 30 von Fig. 1). Eine an der Diode 36 abfallende Diodenspannung und eine von der Hilfsspannungsquelle 52 (z. B. Hilfsspannungsquelle 50 von Fig. 1) erzeugte, im Wesentlichen konstante Hilfsspannung, bilden eine Ansteuerung (z.B. Ansteuerung 40 von Fig. 1) für den Längstransistor 62 (bzw. Leistungsregler 60). Die Funktionsweise der Schutzschaltung 200 wird im Folgenden näher erläutert.

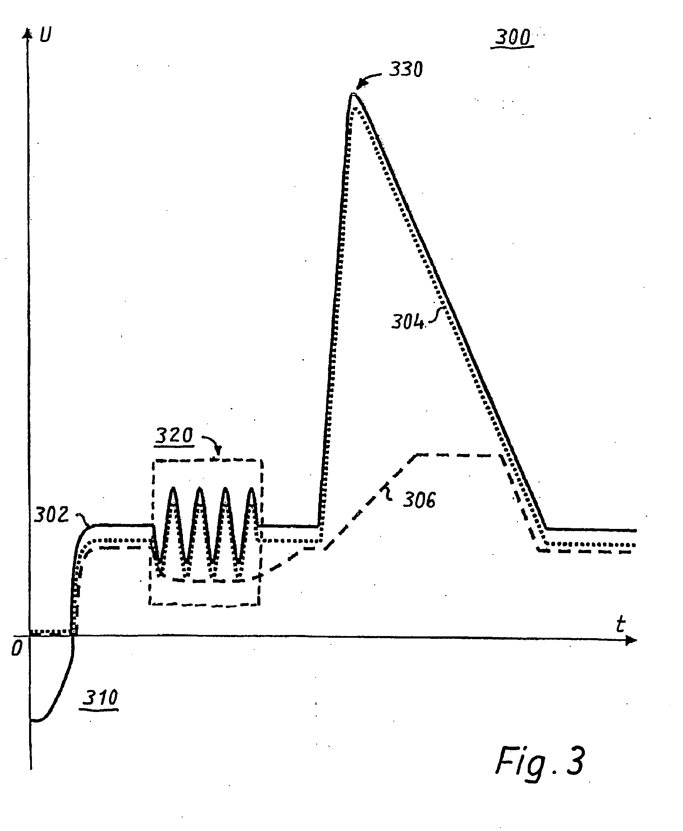

Die Versorgungsspannungsquelle 12 stellt der Schutzschaltung 200 eine Eingangsspannung 302 bereit. Die Eingangsspannung 302 ist vorzugsweise eine im Wesentlichen konstante Gleichspannung mit einer Amplitude von +13,2 V, die von einem Netzgerät oder einer Batterie erzeugt wird. Die Diode 22 ist nur leitend für eine Eingangsspannung mit einer korrekten Polarität, wobei negative Spannungsstörungen in der Eingangsspannung blockiert werden. Eine beispielhafte Eingansspannung 302 ist in Fig. 3 illustriert. Ausgehend von der Eingangsspannung 302 von Fig. 3 erzeugt die Diode 22 eine Spannung 304, welche ebenfalls in Fig. 3 illustriert ist. Die Spannung 304 bewirkt einen Spannungsabfall an der Diode 36, welcher die Entstehung einer entsprechenden Diodenspannung bewirkt. Die Summe der Diodenspannung und der von der Hilfsspannungsquelle 52 erzeugten Hilfsspannung bildet eine Steuerspannung für den Längstransistor 62. Die Hilfsspannung ist vorzugsweise eine im Wesentlichen konstante Gleichspannung mit einer Amplitude von +2 V. Die Steuerspannung ist vorzugsweise derart gestaltet, dass sie annähernd der Schaltschwelle des Längstransistors 62 entspricht. Somit ist die Steuerspannung dazu ausgebildet, den Längstransistor 62 im ohmschen Bereich voll leitend zu steuern, wenn eine von der Versorgungsspannungsquelle gelieferte Eingangsspannung 302 im Wesentlichen frei von elektrischen Störungen ist. Man spricht auch von einem Betrieb im verlustarmen Zustand.

Beim Auftreten von elektrischen Störungen im Niederspannungsbereich mit Frequenzen von 50 Hz bis 20 KHz in der Eingangsspannung 302 und somit in der Spannung 304 wird ein von dem Widerstand 32 und dem Kondensator 34 gebildetes RC-Glied angesprochen. Das RC-Glied filtert die Frequenzkomponenten der Niederspannungsstörungen aus der Spannung 304 aus. Durch ein Ausfiltern der Frequenzkomponenten wird eine negative Spannungsabweichung in der Spannung 304 bewirkt. Diese negative Spannungsabweichung beeinflusst die Diodenspannung an der Diode 36 derart, dass die Steuerspannung abgesenkt wird, woraufhin der Längstransistor 62 im ohmschen Bereich als Widerstand arbeitet. Hierdurch senkt der Längstransistor 62 die Versorgungsspannung an der Last 72 für die Dauer des Auftretens der Niederspannungsstörungen. Nach einem Abklingen der Niederspannungsstörungen steigt die Steuerspannung wieder an und der Längstransistor 62 wird erneut voll leitend gesteuert.

Beim Auftreten von elektrischen Störungen in Form von Transientimpulsen mit Spannungsimpulsen von bis zu +100 V in der Eingansspannung 302 und somit in der Spannung 304 sperrt die Diode 36. Hierdurch wird bewirkt, dass die Schutzschaltung 200 wie ein Netzteil funktioniert - mit einer Ausgangsspannung, die von dem Speicherkondensator 66 bereit gestellt wird und von der Zenerdiode 64 auf die Zenerdiodenspannung begrenzt ist. Anders ausgedrückt wird die Höhe der Spannung 304 beim Auftreten von energiereichen Transientimpulsen durch die Zenerdiode 64 auf einen vorgegebenen Wert begrenzt. Vorzugsweise ist die Zenerdiode 64 derart dimensioniert, dass dieser vorgegebene Wert ungefähr 25% über dem Wert der störungsfreien Spannung 304 liegt. Somit wird erreicht, dass die Zenerdiode 64 ausschließlich dann angesprochen wird, wenn energiereiche Transientimpulse auftreten. Bei einer störungsfreien Eingangsspannung 302 hat die Zenerdiode 64 keinen Einfluss auf die Funktion der Schutzschaltung 200.

Am Ausgang der Schutzschaltung 200 und somit an der Last 72 liegt dementsprechend eine Versorgungsspannung 306 an. Bei der Versorgungsspannung 306 sind gegenüber der Spannung 304 die elektrischen Störungen in der Form von energiereichen Transientimpulsen und Niederspannungen mit Frequenzen von 50 Hz bis 20 KHz reduziert. Eine beispielhafte Versorgungsspannung 306 ist ebenfalls in Fig. 3 illustriert.

**Fig. 3** zeigt eine schematische Darstellung 300 von beispielhaften zeitlichen Verläufen der Spannungen 302, 304 und 306 von Fig. 2.

Die Eingangsspannung 302 stellt eine Nominalspannung zum Betrieb der Last 72 dar. Die Eingangsspannung 302 weist einen Bereich 310 auf, welcher beispielhaft eine negative Spannungskomponente darstellt, d. h. eine Eingangsspannung mit falscher Polarität. Des Weiteren weist die Eingangsspannung 302 einen Bereich 320 auf, der beispielhaft Niederspannungsstörungen illustriert. Darüber hinaus weist die Eingangsspannung 302 einen Bereich 330 auf, der beispielhaft einen energiereichen Transientimpuls illustriert.

Die Spannung 304 entspricht der Eingangsspannung 302, von welcher die negative Spannungskomponente im Bereich 310 durch den durch die Diode 22 gebildeten Verpolschutz entfernt und die Diodenspannung der Diode 22 abgezogen wurde.

Die Versorgungsspannung 306 entspricht der Spannung 304, bei welcher die Niederspannungsstörungen im Bereich 320 und der Transientimpuls im Bereich 330 reduziert wurden. Im Gegensatz zu der Spannung 304 ist die Versorgungsspannung 306 in dem Bereich 320 nach Ausfiltern der Frequenzkomponenten der Niederspannungsstörungen und Absenken der Steuerspannung des Längstransistors 62, wie oben beschrieben, herabgesetzt. Des Weiteren ist der Transientimpuls im Bereich 330 nicht vollständig von der Spannung 304 entfernt worden, sondern in der Versorgungsspannung 306 lediglich im Wesentlichen auf die Spannung der Zenerdiode 64 reduziert worden, d.h. auf eine Gleichspannung mit einer Amplitude von ungefähr +15 V.

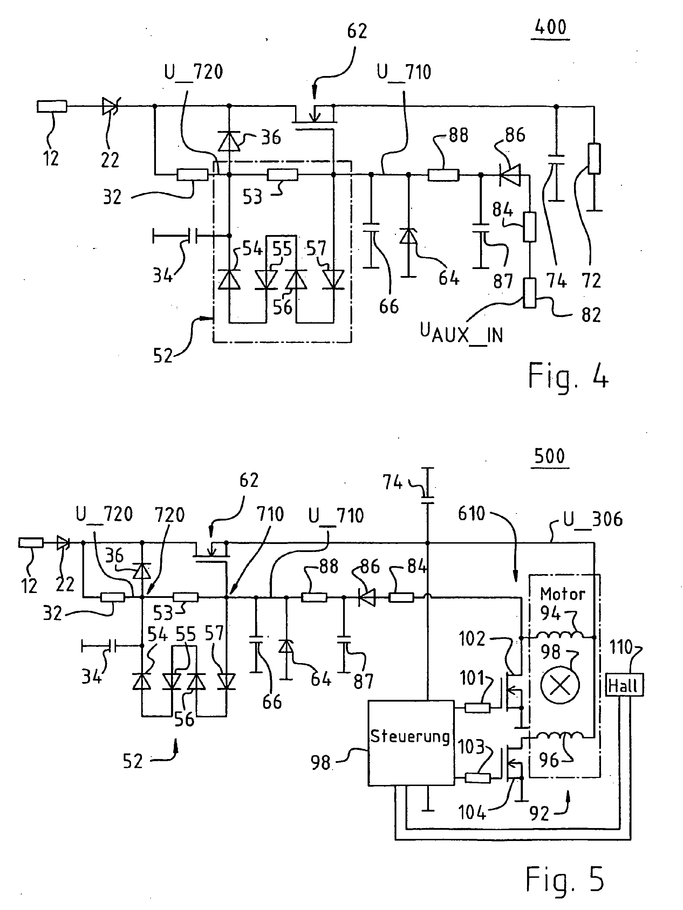

**Fig. 4** zeigt ein stark vereinfachtes Schaltbild einer beispielhaften Schutzschaltung 400 zur Reduzierung von elektrischen Störungen gemäß einer zweiten Ausführungsform der vorliegenden Erfindung. In der Schutzschaltung 400 ist eine Diodenschaltung, in welcher beispielhaft vier Dioden 54, 55, 56 und 57 in Serie geschaltet sind, zwischen dem Gate des Längstransistors 62 und dem Kondensator 34 angeordnet. Parallel zu den vier in Serie geschalteten Dioden 54, 55, 56 und 57 ist ein Widerstand zwischen dem Gate des Längstransistors 62 und dem Widerstand 32 angeordnet. Des Weiteren weist die Schutzschaltung 400 eine Spannungsquelle 82 auf, welche über einen Strombegrenzungswiderstand 84 mit der Anodenseite einer Diode 86 verbunden ist. Die Kathodenseite der Diode 86 ist einerseits über einen Kondensator 87 mit Masse und andererseits über einen Widerstand 88 mit der Kathodenseite der Zenerdiode 64 verbunden. Die übrige Schaltungsanordnung entspricht der aus Fig. 2.

In der Schutzschaltung 400 ersetzt die Parallelschaltung der vier Dioden 54, 55, 56 und 57 mit dem Widerstand 53 die Hilfsspannungsquelle 52 der Schutzschaltung 200 von Fig. 2. Hierzu sind die vier Dioden 54, 55, 56 und 57 derart ausgebildet, dass an ihnen ein Spannungsabfall entsteht, welcher der Hilfsspannung der Hilfsspannungsquelle 52 im Wesentlichen entspricht. Somit muss, um beispielsweise einen Spannungsabfall von +2 V zu erzielen, an jeder der vier Dioden eine Spannung von ungefähr +0,5 V entstehen. Alternativ zu der Serienschaltung der vier Dioden 54, 55, 56 und 57 kann ebenso eine entsprechend dimensionierte Zenerdiode oder Leuchtdiode oder eine Kombination unterschiedlicher Diodentypen verwendet werden.

Der Spannungsabfall an den Dioden 54, 55, 56 und 57 wird ermöglicht durch die Bereitstellung von einer Hilfseingangsspannung U_AUX_IN an der Spannungsquelle 82 mit einer Amplitude von ungefähr +18 V. Durch den Widerstand 84 erfolgt eine Strombegrenzung zum Schutz nachgeschalteter Elemente. Die Diode 86 bewirkt, dass durch die Hilfsspannung U_AUX_IN nur eine Erhöhung der Spannung U_710 am Kondensator 66 stattfinden kann (Prinzip der Ladungspumpe). Darüber hinaus wird die Hilfseingangsspannung U_AUX_IN durch die von dem Kondensator 87 und dem Widerstand 88 gebildete RC-Kombination geglättet.

Es folgen Beispielwerte für die Bauteile aus Fig. 4 (und Fig. 5).

| | |
|---|---|
| Diode 22 | D1FM3 |
| Diode 36 | 1N4148 |
| Dioden 54-57 | 1N4148 |
| Diode 86 | 1N4148 |
| Kondensator 34 | 1 uF |
| Kondensator 66 | 10 nF |
| Kondensator 74 | 100 nF |
| Kondensator 87 | 100 nF |
| Mosfet 62 | IRLR3410 |
| Widerstand 32 | 510 kOhm |
| Widerstand 53 | 510 kOhm |
| Widerstand 84 | 10 kOhm |
| Widerstand 88 | 100 kOhm |
| Zenerdiode 64 | 20 V Zenerdiodenspannung |

**Fig. 5** zeigt ein vereinfachtes Schaltbild einer beispielhaften Schaltung 500, in welcher die Last 72 der Schutzschaltung von Fig. 4 als Gleichstrommotoranordnung ausgebildet ist. Dementsprechend zeigt die Fig. 5 eine beispielhafte Darstellung eines zweisträngigen Elektromotors 92, wie er mit der erfindungsgemäßen Schutzschaltung zur Reduzierung von elektrischen Störungen beschaltet werden kann.

Der elektronisch kommutierte Gleichstrommotor 92 weist zwei Statorwicklungsstränge 94, 96 und einen (nur symbolisch dargestellten) permanentmagnetischen Rotor 98 auf. In der Nähe des Rotors 98 ist ein Hallgenerator 110 angeordnet. Der Strang 94 ist mit dem Drain-Anschluss eines ersten Endstufentransistors 102 (MOSFET) und der Strang 96 mit dem Drain-Anschluss eines zweiten Endstufentransistors 104 (MOSFET) verbunden. Die Stränge 94 und 96 sind einerseits über den Zwischenkreiskondensator 74 mit Masse GND und andererseits mit dem Source-Anschluss des Längstransistors 62 verbunden. Die Stränge 94, 96 sind gewöhnlich über das Eisen des Statorblechpaketes transformatorisch miteinander gekoppelt. Der Gate-Anschluss des Endstufentransistors 102 ist über einen Strombegrenzungswiderstand 101 und der Gate-Anschluss des Endstufentransistors 104 über einen Strombegrenzungswiderstand 103 mit einer Steuerschaltung 98 zur elektronischen Kommutierung der Motorströme verbunden. Der Hallgenerator 110 ist ebenso mit der Steuerschaltung 98 verbunden. Die Source-Anschlüsse der Endstufentransistoren 94, 96 sind mit Masse verbunden.

Bei einer Bestromung des Motors 92 treten an den Wicklungssträngen 94, 96 des Motors 92 Spannungen auf, welche sich u.a. aus induzierten Spannungen durch die Rotormagnete, aus transformatorischen Spannungen durch die gegenüberliegende Wicklung sowie aus durch den hindurchfließenden Strom entstehenden Spannungen zusammensetzen. Diese Spannungen bilden ein Signal 610, welches in bestimmten Bereichen oberhalb der Versorgungsspannung 12 liegt.

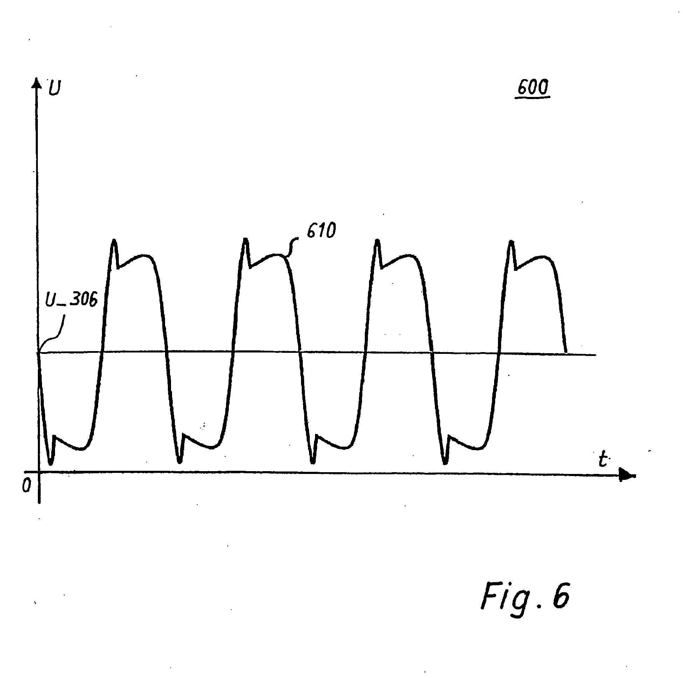

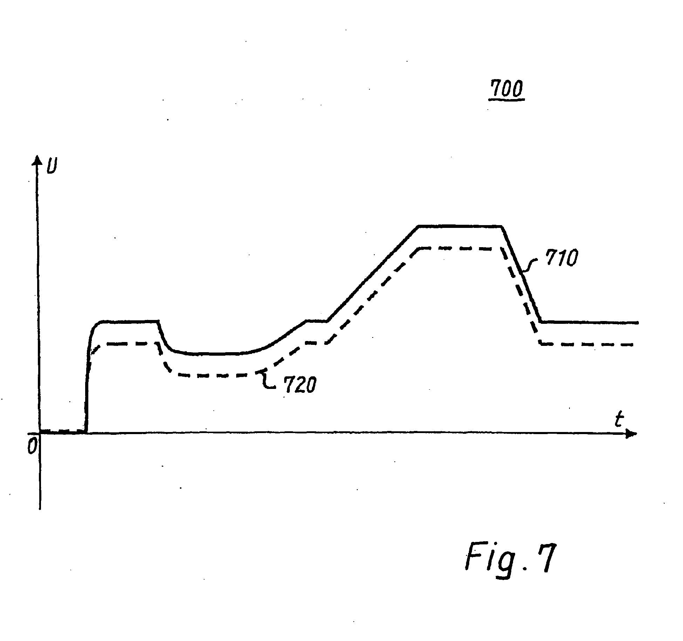

Eine schematische Darstellung 600 eines beispielhaften zeitlichen Verlaufs des Signals 610 bei einer hohen Motorleistung ist in **Fig. 6** gezeigt. Die Spannung 610 ist an einigen Stellen größer als die Versorgungsspannung U_306 und kann daher zur Erzeugung der Hilfsspannung U_710 verwendet werden, vgl. Fig. 5. Wie oben stehend beschrieben erfolgt eine Strombegrenzung des Signals 610 durch den Strombegrenzungswiderstand 84. Durch die Diode 86 kann der sich aus dem Signal 610 ergebende Strom nur in Richtung zum Kondensator 66 fließen, und die RC-Kombination aus Kondensator 87 und Widerstand 88 wirkt als Tiefpass. An die aus den vier Dioden 54, 55, 56 und 57 bestehende Diodenschaltung wird somit ein Signal 710 zur Erzeugung der Hilfsspannung angelegt. Die Diodenschaltung 52 mit den Dioden 54 bis 57 und dem Widerstand 53 bewirkt, dass die als Hilfsspannung für den Längstransistor 62 dienende Spannung U_710 am Punkt 710 mit der Spannung U_720 mitwandert und somit den Längstransistor 62 leitend steuert. Eine schematische Darstellung 700 eines beispielhaften zeitlichen Verlaufs der Signale 710 und 720 ist in **Fig. 7** gezeigt.

Durch die Schutzschaltung gemäß Fig. 5 wird erreicht, dass die Störungen im Niederspannungsbereich sowie durch Transientenimpulse effektiv beseitigt werden. Dabei ist insbesondere vorteilhaft, dass die Hilfsspannung zum Steuern des Längstransistors bzw. Mosfets 62, welche oberhalb der Versorgungsspannung 12 liegen muss, ohne eine zusätzliche Spannungsquelle in Form einer Batterie etc. erzeugt wird. Die Erzeugung der Hilfsspannung durch die Spannung an einer Motorwicklung 94 führt zu einer sicheren und bezüglich der Hilfsspannung wartungsfreien Lösung.

Naturgemäß sind im Rahmen der vorliegenden Erfindung vielfache Abwandlungen und Modifikationen möglich.

## Patentansprüche

1. Elektronisch kommutierter Gleichstrommotor mit einer in seiner Zuleitung angeordneten Schutzschaltung zur Reduzierung elektrischer Störungen beim Betrieb dieses Gleichstrommotors (92), welche Schutzschaltung aufweist:
Einen in einer Zuleitung zum Gleichstrommotor (92) angeordneten Längstransistor (62);
eine diesem Längstransistor zugeordnete Hilfsspannungsquelle (52) mit einer Diodenschaltung (54 bis 57), welche dazu ausgebildet ist, im Betrieb des Gleichstrommotors von einer induzierten Spannung (610), welche an mindestens einem Wicklungsstrang (94) des Gleichstrommotors (92) auftritt, eine im Wesentlichen konstante Hilfsspannung abzuleiten, welche dazu ausgebildet ist, den Längstransistor (62) voll leitend zu steuern, wenn eine von einer Gleichspannungsquelle (12) gelieferte Versorgungsspannung im Wesentlichen frei von elektrischen Störungen ist;
und eine Analysatorschaltung (32, 34, 36) zur Analyse der
Versorgungsspannung, welche Analysatorschaltung dazu ausgebildet ist, beim Auftreten von elektrischen Störungen in der Versorgungsspannung den Widerstand des Längstransistors (62) zu erhöhen, um den Einfluss dieser elektrischen Störungen auf den Betrieb des Gleichstrommotors (92) zu reduzieren.

2. Motor nach Anspruch 1, welcher dazu ausgebildet ist, einer Steuerschaltung (98) des Gleichstrommotors (92) eine im Wesentlichen störungsfreie Versorgungsspannung zuzuführen, welche Steuerschaltung zur elektronischen Kommutierung von in dem Gleichstrommotor fließenden Strömen ausgebildet ist.

3. Motor nach Anspruch 1 oder 2, bei welchem die Analysatorschaltung (32, 34, 36) eine zwischen einer ersten Leitungselektrode des Längstransistors (62) und der Hilfsspannungsquelle (52) angeschlossene Diode (36) aufweist, an welcher eine Diodenspannung abfällt, welche mit der Hilfsspannung eine Steuerspannung zum Steuern des Längstransistors bildet.

4. Motor nach Anspruch 3, bei welchem der Längstransistor (62) ein Feldeffekttransistor ist, und die erste Leitungselektrode der Drain des Feldeffekttransistors ist.

5. Motor nach Anspruch 3 oder 4, bei welchem die Diode (36) dazu ausgebildet ist, die Steuerspannung derart festzulegen, dass ein voll leitender Betrieb des Längstransistors im ohmschen Bereich erfolgt, wenn die von der Gleichspannungsquelle gelieferte Versorgungsspannung im Wesentlichen frei von elektrischen Störungen ist.

6. Motor nach einem der Ansprüche 3 bis 5, bei welchem die Diode (36) dazu ausgebildet ist, den Längstransistor (62) beim Auftreten von elektrischen Störungen in Form von Transientenimpulsen in der Versorgungsspannung höherohmig zu schalten.

7. Motor nach Anspruch 6, welcher eine zwischen einer zweiten Leitungselektrode des Längstransistors (62) und Masse angeschlossene Zenerdiode (64) aufweist, die dazu ausgebildet ist, die Höhe der von der Schutzschaltung erzeugten Versorgungsspannung auf einen vorgegebenen Wert zu begrenzen.

8. Motor nach Anspruch 7, bei welchem der Längstransistor ein Feldeffekttransistor (62) und die zweite Leitungselektrode das Gate des Feldeffekttransistors ist.

9. Motor nach einem der Ansprüche 3 bis 8, bei welchem die Analysatorschaltung (32, 34, 36) ein RC-Glied (32, 34) aufweist, welches RC-Glied dazu ausgebildet ist, bei elektrischen Störungen in Form von Niederspannungen mit Frequenzen von 50 Hz bis 20 kHz in der Versorgungsspannung die Frequenzkomponenten auszufiltern.

10. Motor nach Anspruch 9, bei welchem die Diodenspannung dazu ausgebildet ist, die Steuerspannung abzusenken, um den Längstransistor leitend im ohmschen Bereich zu betreiben.

11. Motor nach einem der vorhergehenden Ansprüche, welcher einen Verpolschutz (20, 22) aufweist.

## Claims

1. Electronically commutated direct-current motor with a protective circuit disposed in its feed line for reducing electrical faults when the said direct-current motor (92) is operating, which protective circuit has:
- a series pass transistor (62) disposed in a feed line to the direct-current motor (92);
- an auxiliary voltage source (52) which is associated with the said series pass transistor and has a diode circuit (54 to 57) which is designed for the purpose of shunting off, when the direct-current motor is in operation, from an induced voltage (610) which occurs on at least one winding phase (94) of said direct-current motor (92), a substantially constant auxiliary voltage which is designed for the purpose of controlling the series pass transistor (62) in a fully conductive manner if a supply voltage delivered by a direct-current voltage source (12) is substantially free from electrical faults;
- and an analyser circuit (32, 34, 36) for analysing the supply voltage, which analyser circuit is designed for the purpose of increasing the resistance of the series pass transistor (62) when electrical faults occur in the supply voltage, in order to reduce the influence of the said electrical faults on the operation of the direct-current motor (92).

2. Motor according to claim 1, which is designed for the purpose of feeding, to a control circuit (98) of the direct-current motor (92), a substantially fault-free supply voltage, which control circuit is designed for the purpose of electronically commutating currents which are flowing in said direct-current motor.

3. Motor according to claim 1 or 2, in which the analyser circuit (32, 34, 36) has a diode (36) which is connected between a first line electrode of the series pass transistor (62) and the auxiliary voltage source (52) and at which a diode voltage, which forms, with the auxiliary voltage, a control voltage for controlling the series pass transistor, drops.

4. Motor according to claim 3, in which the series pass transistor (62) is a field-effect transistor, and the first line electrode is the drain of said field-effect transistor.

5. Motor according to claim 3 or 4, in which the diode (36) is designed for the purpose of fixing the control voltage in such a way that fully conductive operation of the series pass transistor takes place in the ohmic range if the supply voltage delivered by the direct-current voltage source is substantially free from electrical faults.

6. Motor according to one of claims 3 to 5, in which the diode (36) is designed for the purpose of switching the series pass transistor (62) to a higher resistance when electrical faults in the form of transient pulses occur in the supply voltage.

7. Motor according to claim 6, which has a Zener diode (64) which is connected between a second line electrode of the series pass transistor (62) and earth and which is designed for the purpose of limiting the magnitude of the supply voltage generated by the protective circuit to a predetermined value.

8. Motor according to claim 7, in which the series pass transistor is a field-effect transistor (62) and the second line electrode is the gate of said field-effect transistor.

9. Motor according to one of claims 3 to 8, in which the analyser circuit (32, 34, 36) has an RC module, which RC module is designed for the purpose of filtering out the frequency components in the event of electrical faults in the form of low voltages with frequencies of 50 Hz to 20 kHz in the supply voltage.

10. Motor according to claim 9, in which the diode voltage is designed for the purpose of lowering the control voltage in order to operate the series pass transistor in a conductive manner in the ohmic range.

11. Motor according to one of the preceding claims, that has polarity protection (20, 22).

## Revendications

1. Moteur à courant continu à commutation électronique avec un circuit de protection disposé dans sa ligne d'alimentation pour réduire les perturbations électriques lors du fonctionnement de ce moteur à courant continu (92), lequel circuit de protection présente :
un transistor série (62) disposé dans une ligne d'alimentation du moteur à courant continu (92) ;
une source de tension auxiliaire (52) associée à ce transistor série, avec un circuit à diodes (54 à 57) qui est réalisé pour, pendant le fonctionnement du moteur, dériver d'une tension induite (610) qui apparaît à la phase d'enroulement (94) au nombre d'au moins une du moteur à courant continu (92) une tension auxiliaire essentiellement constante qui est réalisée pour commander le transistor série (62) à pleine conduction quand une tension d'alimentation fournie par une source de tension continue (12) est essentiellement exempte de perturbations électriques ;
et un circuit analyseur (32, 34, 36) pour analyser la tension d'alimentation, lequel circuit analyseur est réalisé pour augmenter la résistance du transistor série (62) en cas d'apparition de perturbations électriques dans la tension d'alimentation, afin de réduire l'influence de ces perturbations électriques sur le fonctionnement du moteur à courant continu (92).

2. Moteur selon la revendication 1, lequel est conçu pour amener à un circuit de commande (98) du moteur à courant continu (92) une tension d'alimentation essentiellement exempte de perturbations, lequel circuit de commande est réalisé pour commuter électroniquement des courants circulant dans le moteur à courant continu.

3. Moteur selon la revendication 1 ou 2, dans lequel le circuit analyseur (32, 34, 36) présente une diode (36) connectée entre une première électrode de ligne du transistor série (62) et la source de tension auxiliaire (52), sur laquelle chute une tension de diode qui forme avec la tension auxiliaire une tension de commande pour commander le transistor série.

4. Moteur selon la revendication 3, dans lequel le transistor série (62) est un transistor à effet de champ et la première électrode de ligne le drain du transistor à effet de champ.

5. Moteur selon la revendication 3 ou 4, dans lequel la diode (36) est réalisée pour définir la tension de commande de façon qu'un fonctionnement à pleine conduction du transistor série ait lieu dans le domaine ohmique si la tension d'alimentation fournie par la source de tension continue est essentiellement exempte de perturbations électriques.

6. Moteur selon l'une des revendications 3 à 5, dans lequel la diode (36) est réalisée pour augmenter la valeur ohmique du transistor série (62) en cas d'apparition de perturbations électriques sous la forme d'impulsions transitoires dans la tension d'alimentation.

7. Moteur selon la revendication 6, lequel présente une diode Zener (64) connectée entre une deuxième électrode de ligne du transistor série (62) et la masse, laquelle est réalisée pour limiter, à une valeur prédéfinie, le niveau de la tension d'alimentation générée par le circuit de protection.

8. Moteur selon la revendication 7, dans lequel le transistor série est un transistor à effet de champ (62) et la deuxième électrode de ligne la grille du transistor à effet de champ.

9. Moteur selon l'une des revendications 3 à 8, dans lequel le circuit analyseur (32, 34, 36) présente un circuit RC (32, 34), lequel circuit RC est réalisé pour filtrer les composantes fréquentielles en cas de perturbations électriques sous la forme de basses tensions de fréquences comprises entre 50 Hz à 20 kHz dans la tension d'alimentation.

10. Moteur selon la revendication 9, dans lequel la tension de diode est réalisée pour diminuer la tension de commande pour faire fonctionner le transistor série en conduction dans le domaine ohmique.

11. Moteur selon l'une des revendications précédentes, lequel présente une protection contre l'inversion de polarité (20, 22).
